Europäisches Patentamt

European Patent Office

Office européen des brevets

(11) Publication number: **0 427 105 A1**

# EUROPEAN PATENT APPLICATION

(21) Application number: **90120895.9**

(22) Date of filing: **31.10.90**

(51) Int. Cl.⁵: **H03H 11/12, G01D 5/245**

(30) Priority: **07.11.89 IT 6797389**

(43) Date of publication of application:
**15.05.91 Bulletin 91/20**

(84) Designated Contracting States:
**BE CH DE ES FR GB LI NL SE**

(71) Applicant: **MARELLI AUTRONICA S.p.A.**
**Piazza S.Ambrogio 6**
**I-20123 Milano(IT)**

(72) Inventor: **Ghisio, Guido**
**Corso Regina Margherita 187**
**I-10144 Torino(IT)**
Inventor: **Mazzucco, Michelangelo**
**Strada Valenza 22, I-15040 Santa Maria**
**Tempio**
**Fraz. Casale Monf., Alessandria(IT)**

(74) Representative: **Quinterno, Giuseppe et al**
**c/o Jacobacci-Casetta & Perani S.p.A. Via**
**Alfieri, 17**
**I-10121 Torino(IT)**

(54) **A circuit for processing the signal generated by an electromagnetic rotation sensor.**

(57) The circuit comprises a low-pass filter (6) for filtering the signal ($V_f$) output by the sensor (1-4), and a processing and comparison circuit (7) which outputs a signal ($V_o$) at a first level when the signal ($V_f$) output by the filter (6) crosses a first threshold and at a second level when the signal ($V_f$) crosses a second threshold.

The filter (6) is of the type whose cut-off frequency is variable in dependence on the amplitude of a control signal.

A frequency/voltage converter (14) supplies the filter (6) with a control signal whose amplitude is a function of the frequency of the signal ($V_o$) output by the processing and comparison circuit (7) so that the cut-off frequency of the filter (6) is lowered or raised adaptively according to whether the frequency of the signal ($V_o$) output by the processing and comparison circuit (7) decreases or increases.

EP 0 427 105 A1

# A CIRCUIT FOR PROCESSING THE SIGNAL GENERATED BY AN ELECTROMAGNETIC ROTATION SENSOR

The present invention relates to a circuit for processing the signal generated by an electromagnetic rotation sensor with variable reluctance.

More specifically, the invention relates to a circuit including:
low-pass filter circuit means for filtering the signal output by the sensor, and
a processing and comparison circuit for outputting a signal which assumes a first level when the signal output by the filter means crosses a first threshold and a second level when the signal crosses a second threshold.

Typically, a variable-reluctance rotation sensor comprises a rotor which has a series of teeth or notches in suitable positions and is associated with an inductive pick-up. When the rotor is rotated, each time one of its teeth passes in front of the pick-up, the latter provides a signal whose amplitude is at first positive, then passes through zero and becomes negative.

There are various applications for sensors of this type, particularly in the automotive sector, for example, for detecting the rate of rotation of the engine shaft or for detecting the moments at which the pistons of the engine pass through top or bottom dead centre.

A circuit for processing the signal generated by such a sensor is described, for example, in the European Patent Application published under the number 166699 in the name of the same Applicant.

The signal supplies by a variable-reluctance sensor of the type described above has the characteristic that its range, that is, the fluctuation of its amplitude, varies greatly with variations in frequency. In particular, its amplitude fluctuation increases in a non-linar manner as the frequency increases. Thus, for example, in a known sensor, at frequencies of 25 Hz, 500 Hz and KHz, the signal assumes amplitudes of 100 mV, 2V and 150 V respectively. (With reference to the last value, it should be noted that the signal output by the sensor is usually "cut off" at a predetermined maximum level, for example, of 5V).

Since the range of the signal from a variable-reluctance sensor varies greatly with frequency, for some applications, for example, for determining the ignition timing in an internal combustion engine, the signal is compared not with a threshold of fixed value but with a threshold which is varied adaptively in dependence on the amplitude of the signal output by the sensor. The threshold is thus increased with increases in the amplitude (and hence the frequency) of the sensor signal.

When a variable-reluctance sensor is used in a motor vehicle, spurious signals or interference may be superposed on the signal generated by the sensor. In the frequency range of interest as regards the sensor signal, that is, for example, below 10 KHz, these spurious signals or interference may have components with amplitudes of the order of 1V and hence comparable with the amplitude of the sensor signal.

The superposition of spurious signals or interference on the signal generated by the sensor causes errors in the subsequent processing of the signal. Thus, if the signal output by the sensor is used for determining the ignition timing in an internal combustion engine, the spurious signals or interference may lead to premature or retarded sparking in one or more cylinders, with well-known consequences.

The object of the present invention is to provide a circuit for processing the signal from a variable-reluctance sensor which drastically reduces the effect of the spurious signals or interference.

The present invention is based on the observation that, at least as a first approximation, the range of spurious signals or interference encountered in automotive applications is substantially constant with variations in frequency.

According to the invention, the aforesaid object is achieved by means of a circuit of the type specified above, whose main characteristic lies in the fact that:
the filter circuit means are of the type whose cut-off frequency is variable in dependence on the amplitude of a control signal, and in that
a frequency/voltage converter is provided for supplying the filter circuit means with a control signal whose amplitude is a function of the frequency of the signal output by the processing and comparison circuit so that the cut-off frequency of the filter circuit means is lowered or raised adaptively according to whether the frequency of the signal output by the processing and comparison means decreases or increases.

In the circuit according to the invention, at low frequencies, the input signal, that is, the signal output by the sensor with any interference superposed thereon, undergoes low-pass filtering with a very narrow pass band. Thus, at low frequencies, that is, when the amplitude of the signal generated by the senscr has quite a narrow range, the noise is filtered more effectively.

At higher frequencies, on the other hand, the signal applied to the input of the circuit according to the invention undergoes low-pass filtering with quite a high upper cut-off frequency so as not to lose data from the actual sensor signal. At high frequencies, however, the effect of. the interference is intrinsically less important since, as stated above, the signal generated by the sensor has quite a wide range at high frequencies.

Compared with prior-art devices, the circuit according to the invention thus improves the signal/noise ratio, particularly at medium and low frequencies.

Further characteristics and advantages of the invention will become clear from the detailed description which follows with reference to the appended drawings, provided purely by way of non-limiting example, in which:

Figure 1 is a block diagram showing the structure of a circuit according to the invention, and

Figure 2 is a circuit diagram, partially in block form, which shows an embodiment of a filter circuit included in the circuit of Figure 1.

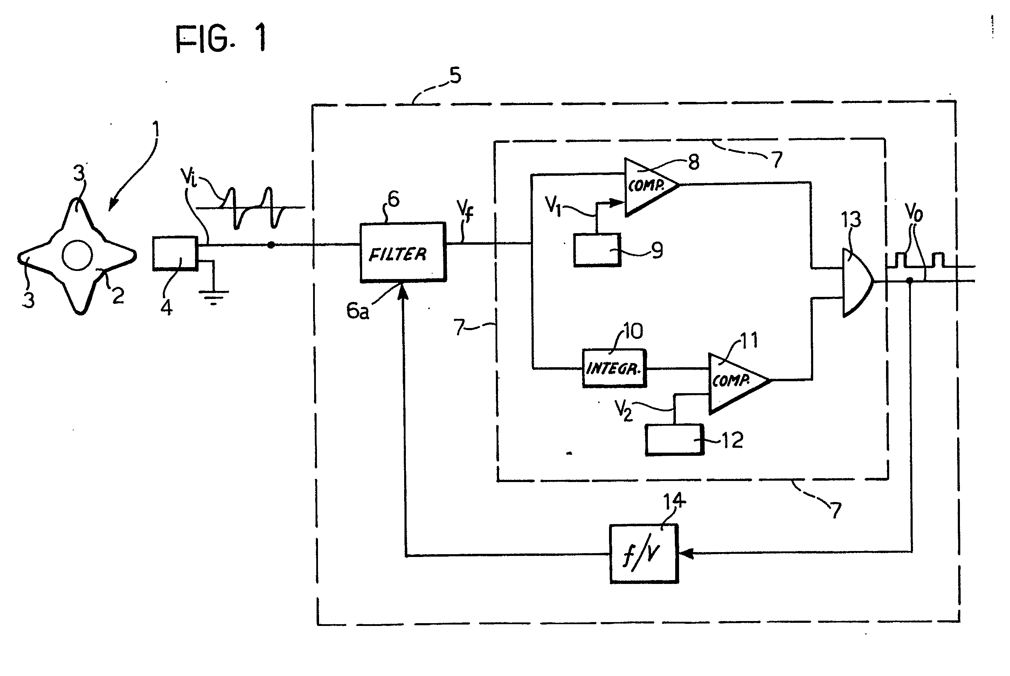

In Figure 1, a variable-reluctance rotation sensor, generally indicated 1, comprises a rotor(2)with a plurality of teeth 3 in suitably selected angular positions.

An inductive pick-up, indicated 4, is associated with the rotor 2.

When the rotor 2 is rotated, each time one of its teeth 3 passes in front of the pick-up 4, the latter outputs a voltage signal whose amplitude is positive initially and then, after passing through zero, becomes negative.

A circuit according to the invention for processing the signal output by the sensor 1 is indicated 5 in Figure 1.

The processing circuit 5 includes a low-pass filter circuit 6 of the type whose (upper) cut-off frequency is variable in dependence on the amplitude of a control signal applied to an input 6a of the circuit.

The output of the filter circuit 6 is connected to the input of a processing and comparison circuit, generally indicated 7. This circuit is arranged to output a pulsed signal whose trailing edges (for example) correspond to the passage of the signal output by the filter circuit 6 through zero.

Conveniently, the processing and comparison circuit 7 is produced in accordance with European Patent Application 0166699 and comprises a threshold comparator 8 with hysteresis which outputs (for example) a signal at level "1" when the amplitude of the signal $V_f$ output by the filter 6 exceeds a positive threshold $V_1$ defined by a generator, indicated 9, and at level "0" when the signal $V_f$ passes through zero to become negative.

An integrator 10 is connected to the output of the filter circuit 6 and its output is connected in turn to the input of a further threshold comparator 11 which outputs a signal at level "1" only when the amplitude of the integrated signal exceeds a threshold $V_2$ provided by a source, indicated 12.

The outputs of the comparators 8 and 11 are connected to the inputs of a logic circuit 13, such as, for example, an AND gate: the signal output by the comparator 8 can pass to the output of the logic circuit 13 only when the output of the comparator 11 is at level "1" and thus when the energy of the signal at the input of the processing and comparison circuit 7 exceeds a predetermined level. This eliminates the effect of pulsed interference in the manner described in the European patent application cited above.

According to the invention, the output of the logic circuit 13 is connected to the input of a frequency/voltage converter 14. This converter supplies the input 6a of the filter circuit 6 with a control signal whose amplitude is a function of the frequency of the signal $V_o$ output by the processing and comparison circuit 7.

According to the amplitude of the signal received at the input 6a, the filter circuit 6 modifies its own cut-off frequency, in particular reducing it or raising it according to whether the amplitude of the signal received at its input 6a decreases or increases.

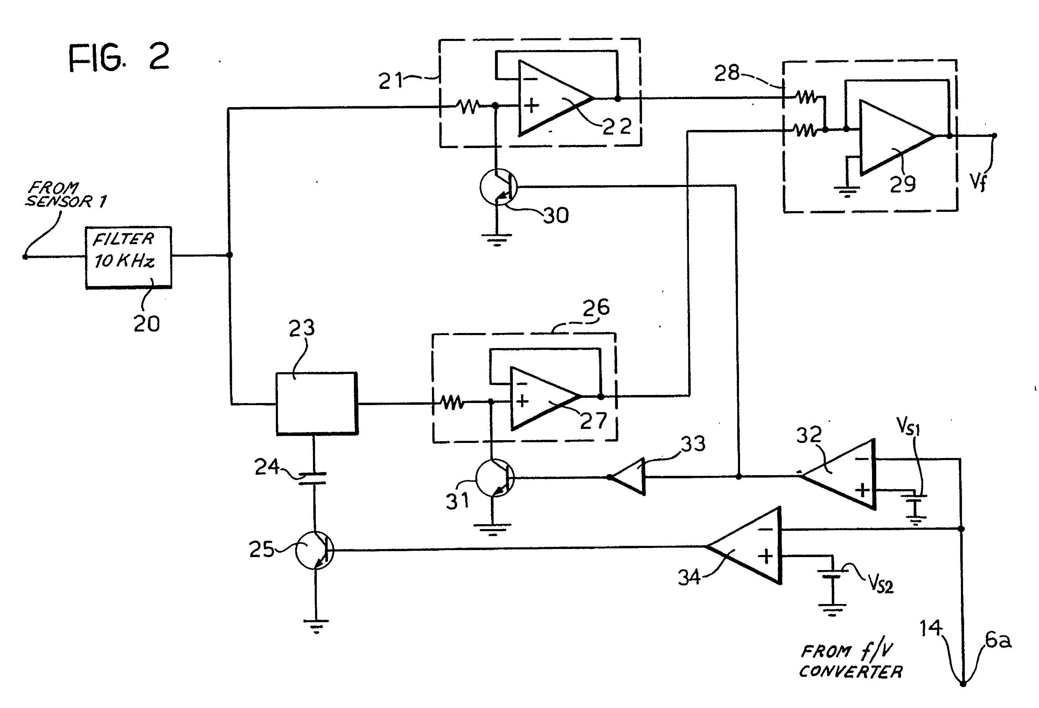

An embodiment of the filter circuit 6, which is adapted to act as a low-pass filter whose cut-off frequency is variable by discrete values in dependence on the amplitude of the control signal, will now be described with reference to Figure 2.

In Figure 2, a low-pass filter with a cut-off frequency greater than, for example, 10 KHz is indicatd 20. The input of this filter is intended to be connected to the inductive pick-up 4.

The output of the filter 20 is connected to a voltage-follower circuit 21 produced in known manner with the use of an operational amplifier 22, and to the input of a further filter 23. A capacitor 24 is associated with this latter filter and can be connected to earth by means of a transistor 25. The upper cut-off frequency of the low-pass filter 23 can assume a first or second value (for example, 250 Hz or 500 Hz) according to whether the capacitor 24 is connected or disconnected, that is, according to whether the transistor 25 is conductive or cut off.

The output of the filter 23 is connected to a voltage-follower circuit 26 including an operational amplifier 27.

The outputs of the circuits 21 and 26 are connected to corresponding inputs of an analog adder 28 produced in known manner with the use of an operational amplifier 29. The output of the adder constitutes the output of the filter circuit 6.

Two transistors 30 and 31 are provided between the non-inverting inputs of the operational amplifiers 22, 27 and earth. The bases of these transistors are connected to the output of a threshold comparator 32 directly and by means of an inverter 33, respectively. The comparator has an input connected to the input 6a of the filter circuit for receiving the signal output by the frequency/voltage converter 14.

A further threshold comparator circuit 43 has an input connected to the terminal 6a and its output connected to the base of the transistor 25.

In operation, the comparators 32 and 34 compare the signal from the frequency/voltage converter 14 with respective threshold reference signals $V_{s1}$, $V_{s2}$ corresponding to predetermined frequency values of the signal $V_o$ output by the processing and comparison circuit 7 of Figure 1.

When the signal applied to the terminal 6a of the filter circuit 6 indicates that the frequency of the signal $V_o$ is above an upper threshold associated with the reference voltage $V_{s1}$, the comparator 32 cuts off the transistor 30 and - by means of the inverter 33 -makes the transistor 31 conductive. The signal output by the filter 20 consequently reaches the adder 28 through the voltage-follower circuit 21, whilst the output of the filter 23 is disconnected from the adder. In this condition, the filter circuit 6 as a whole thus acts as a low-pass filter with an upper cut-off frequency equal to the cut-off frequency of the filter 20.

When the frequency of the signal $V_o$ falls below the value associated with the threshold voltage $V_{s1}$, the comparator 32 makes the transistor 30 conductive and cuts off the transistor 31. The connection of the filter 20 to the adder 28 through the voltage-follower circuit 21 is consequently disabled, whilst the connection through the filter 23 and the voltage-follower circuit 26 is enabled.

In this condition, if the frequency of the signal $V_o$ is greater than the value associated with the threshold voltage $V_{s2}$, the comparator 34 makes the transistor 25 conductive so that the filter 23 acts as a low-pass filter with a cut-off frequency of 500 Hz.

If the frequency of the signal $V_o$ is below the value associated with the reference voltage $V_{s2}$, however, the comparator 34 disables the transistor 25 and the filter 23 acts as a filter with a lower cut-off frequency, that is, 250 Hz in the example referred to above.

Naturally, the principle of the invention remaining the same, the forms of embodiment and details of construction may be varied widely with respect to those described and illustrated purely by way of non-limiting example, without thereby departing from the scope of the present invention.

## Claims

1. A circuit for processing the signal generated by an electromagnetic rotation sensor (1-4) with variable reluctance, including:

low-pass filter circuit means (6) for filtering the signal output by the sensor (1-4), and
a processing and comparison circuit (7) adapted to output a signal ($V_o$) which can assume a first level when the signal ($V_f$) output by the filter means (6) exceeds a first threshold, and a second level when the signal ($V_f$) crosses a second threshold, characterised in that
the filter circuit means (6) are of the type whose cut-off frequency can be varied in dependence on the amplitude of a control signal, and in that
a frequency/voltage converter (14) is provided for supplying the filter circuit means (6) with a control signal whose amplitude is a function of the frequency of the signal ($V_o$) output by the processing and comparison circuit (7) so that the cut-off frequency of the filter circuit means (6) is lowered or raised adaptively according to whether the frequency of the signal ($V_o$) output by the processing and comparison means (7) decreases or increases.

2. A circuit according to Claim 1, characterised in that the filter circuit means (6) are adapted to act as a low-pass filter whose cut-off frequency can be varied by discrete values in dependence on the amplitude of the control signal.

3. A circuit according to Claim 2, characterised in that the filter circuit means comprise:
a filter (23) whose cut-off frequency can assume a first or a second value according to whether an associated reactive, in particular capacitive, element (24) is connected or disconnected, and
comparison and control circuit means (34) for connecting or disconnecting the reactive element (24) according to the amplitude of the control signal.

4. A circuit according to Claim 2 or Claim 3, characterised in that the filter circuit means (6) comprise:
at least first and second low-pass filters (2a, 23) with different respective cut-off frequencies, between the sensor (1-4) and the processing and comparison circuit (7), and
comparison and control circuit means (30-33) adapted selectively to enable the first and/or the second filter (20, 23) according to the amplitude of the control signal.

5. A circuit according to Claim 4, characterised in that the filter circuit means (6) comprise:
a first filter (20) with a first cut-off frequency,
a second filter (22) connected to the output of the first filter (20) and having a second cut-off frequency lower than the first cut-off frequency;
an adder (28) having first and second inputs connected to the output of the first and second filters (20, 23) respectively, and
comparison and control circuit means (30-33) adapted selectively to control the connections between the filters (20; 23) and the associated inputs of the adder (28) according to the amplitude of the control signal.

6. A circuit according to Claim 5, characterised in that the cut-off frequency of the second filter (23) can have a first or second value according to whether an associated reactive, in particular capacitive, element (24) is connected or disconnected.

FIG. 1

EP 0 427 105 A1

FIG. 2

FROM SENSOR 1

FILTER 10 KHz — 20

Vf

29

28

22

21

30

26

27

31

23

24

25

33

32

$V_{S1}$

$V_{S2}$

34

14

6a

FROM f/v CONVERTER

European
Patent Office

**EUROPEAN SEARCH
REPORT**

Application Number

**EP 90 12 0895**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,Y | EP-A-0 166 699   (MARELLI AUTRONICA SPA)<br>* abstract *<br>— — — | 1 | H 03 H 11/12<br>G 01 D 5/245 |
| Y | GB-A-2 077 559   (NATIONAL RESEARCH DEVELOPMENT CORPORATION)<br>* page 2, lines 10 - 50 *<br>— — — | 1 | |
| A | NL-A-7 205 691   (AHREND-VAN GOGH N.V.)<br>* figures 1, 2 *<br>— — — | 2,3,6 | |
| A | EP-A-0 137 462  (HITACHI LTD)<br>* page 7, lines 2 - 17; figure 12 *<br>— — — — — | 4,5 | |

TECHNICAL FIELDS
SEARCHED (Int. Cl.5)

G 01 D
H 03 H

The present search report has been drawn up for all claims

| Place of search | Date of completion of search | Examiner |
|---|---|---|
| The Hague | 23 January 91 | LUT K. |